# EUROPEAN PATENT APPLICATION

(11) **EP 1 783 838 A1**
(43) Date of publication of application: **09.05.2007**
(21) Application number: 05753466.1
(22) Date of filing: 22.06.2005
(51) Int. Cl.: H01L 33/00

(54) **WHITE LIGHT-EMITTING DEVICE AND METHOD FOR PRODUCING SAME**

(30) Priority: 23.06.2004 JP 2004185617
(71) Applicant: ROHM CO., LTD., Kyoto-shi, Kyoto 615-8585 (JP)
(72) Inventor: Yamaguchi, Tomoji, Rohm Co., Ltd, Kyoto-shi, Kyoto, 6158585 (JP)
(74) Representative: TBK-Patent
(86) International application number: PCT/JP2005/011429
(87) International publication number: WO 2006/001297

(57) **Abstract**

There are provided a white light emitting device of high luminous efficiency prevented from luminance deterioration even in large electric current range, and a method for manufacturing the same with high production yield. The white light emitting device (1) is composed of a blue LED element (4) and an oxide layer (8) containing a fluorescent material which is integrated with the blue LED element (4). In the blue LED element (4), a p-side electrode (11) is formed on a surface of a p-type layer of epitaxial layers (6) formed by laminating GaN based compound semiconductor layers on a surface of a light transmitting crystal substrate (3), and an n-side electrode (10) is formed on a bottom surface of a recessed portion (9) which is an n-type layer exposed by selectively etching a part of the p-type layer and the light emitting layer. The oxide layer (8) is formed by sintering a YAG fluorescent material and a glass binder containing mainly SiO₂, B₂O₃ and PbO for binding the fluorescent material. The white light emitting device emits white light to the out side by converting blue light emitted from the blue LED element in the oxide layer (8).

## Description

### FIELD OF THE INVENTION

The present invention relates to a white light emitting device emitting white light and a method for manufacturing the same. More particularly, the present invention relates to a white light emitting device (white LED device) provided with a light emitting layer formed by laminating GaN based compound semiconductor layers and composed so as to emit white light outside from the light emitting layer through a fluorescent material layer, and relates to a method for manufacturing the same.

### BACKGROUND OF THE INVENTION

In recent years, gallium-nitride based (GaN based) compound semiconductors made of GaN, GaAlN, InGaN, InAlGaN or the like which are compounds of Ga (gallium), Al (aluminum), In (indium) or the like, are widely used as semiconductor materials for visible light emitting devices, and development thereof especially in a field of blue LEDs has been promoted. In an example of the light emitting devices using LEDs of these kinds by the prior art, the detailed fundamental structure of the LED is formed, for example on a sapphire substrate, by laminating a buffer layer, an n-type layer, an active layer composed of SQW, MQW or the like and a p-type layer which are formed by using GaN based compound semiconductor layers (cf. for example Fig.12 in PATENT DOCUMENT 1).

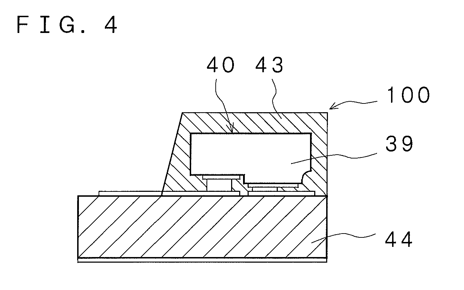

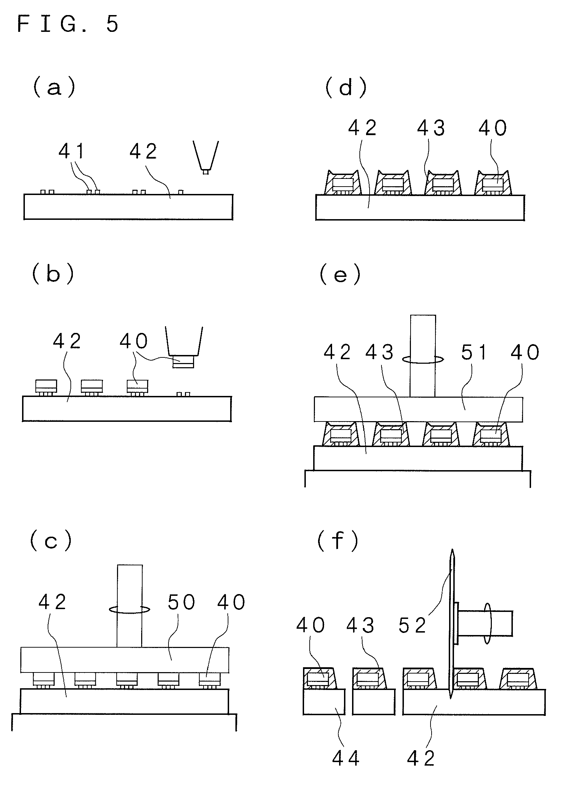

In this case, a white light emitting device 100 of a hybrid structure such as shown, for example, in Fig. 4 is known as a white light emitting device having a protective diode built in. In this structure, white light is emitted outside by mixing light from a light emitting element (blue LED) 40 emitting blue light and light through a fluorescent material layer 43 emitting light of a complimentary color by the blue light. Also in this case, an insulating sapphire substrate is generally used as a light transmitting crystal substrate 39 to grow semiconductor layers thereon, and the blue LED element is mounted on a sub-mount member (zener diode) 44 formed with a Si substrate in a flip-chip manner so as to take out electrodes from the blue LED element 40 (to be electrically conducted). For a method thereof, for example, a method shown in Figs. 5 is employed (cf. for example PATENT DOCUMENT 1 and 2).
PATENT DOCUMENT 1: Japanese Patent Application Laid-Open No. 2001-15817
PATENT DOCUMENT 2: Japanese Patent Application Laid-Open No. 2002-158377

### DISCLOSURE OF THE INVENTION

### PROBLEM TO BE SOLVED BY THE PRESENT INVENTION

Then, for example, in a case of a white light emitting device 100 of a conventional hybrid type using a blue LED element as shown in Fig. 4, white light is emitted outside as a result of: taking out blue light from a surface of a sapphire substrate 39 side of a blue LED element 40 mounted on a sub-mount member 44 in which a Zener diode is formed; converting the blue light to yellow-green light of a complimentary color with a YAG fluorescent material 43 coated on a surrounding of the blue LED element by using resin as a binder; and adding and mixing these lights. In this case, efficiency of taking light out of the blue LED element 40 is highest in this structure and the structure is also excellent. Next four reasons are listed for this.

Firstly, since there exists no barrier like electrodes or the like to inhibit taking light out above a surface of the sapphire substrate 39 from which a principal light is taken out, the efficiency of taking light out is higher by 30% or more compared to that of a light emitting device of a type taking light out from a side of a surface on which an electrode is formed, through a transparent electrode.

Secondly, since electrodes are located on a lower surface opposite to an upper surface of the sapphire substrate 39 from which the principal light is taken out, by using a material of high reflection coefficient for electrodes, the electrodes can work as a reflection mirror of light reflecting light traveling downward so as to travel upward by the reflection mirror (reflection electrodes), thereby the efficiency of taking light out is improved by 50% or more.

Thirdly, since refractive indexes decrease stepwise such as 2.1 of the light emitting layer of a GaN based compound semiconductor, 1.7 of the sapphire substrate, and 1.5 of the resin for the binder of the fluorescent material layer, an effect of inhibiting loss of light at boarder surfaces between each layers can be additionally obtained.

Fourthly, since the upper surface of the sapphire substrate 39 from which the principal light is taken out can be worked in a state of frosted glass by frosting or a surface provided with grooves in order to improve the efficiency of taking light out, the efficiency of taking light out can be improved by 20% or more thereby.

As a still larger effect in addition to the effects described above, the zener diode 44 of the sub-mount works as a protective device for the blue LED element 40 which is weak against static electricity, and has been capable of protecting the blue LED element 40 against a forward and reverse surge voltage of 1 kV.

As described above, the white light emitting device 100 of a hybrid type mounted in the flip-chip manner shown in Fig. 4 has an excellent structure for applications used in a low current range (If ≦ 20 mA for a LED having a usual size of a bottom area of 0.3 mm²) such as a back light source or the like used in a display portion of portable telephones used at a room temperature, because it has many merits in comparison with a blue LED element of a structure taking light out from a transparent electrode side, even though its structure is complicated.

However, this structure raises a big problem in case of operating in a large current and a high luminance such as in an application of lighting. As a remarkably much heat is generated in the blue LED element by the large current, a change of color of the resin for the binder can not be avoided because the binder to coat the fluorescent material is made of resin, even in a good design for heat dissipation, and therefor the luminous efficiency deteriorates significantly. For example, when a current of If=20 mA is applied to a chip LED of a side-view type (LED of a surface mount chip type emitting light in a direction parallel to a mounting surface) used in portable telephones, in which a chip size of the blue LED element 40 is 0.3 mm x 0.3 mm x 0.1 mm (thickness) and in which the epoxy resin is used as the binder, at an ambient temperature Ta of 85°C, a luminance (total flux of light) deteriorates to approximately 50% of an initial luminance in an energized period of 1,000 hours. A cause of this is not deterioration of the blue LED device but decrease of a light transmissivity caused by a change of color of the epoxy resin which is used for the binder of the fluorescent material layer by heat. Even in case that silicone resin which is strong against a high temperature in a change of color is used for the binder, a luminance deteriorates to approximately 50% of an initial luminance in an energized period of 2,000 hours with energizing at the same ambient temperature.

In case that a large current is applied for an application of lighting, as the ambient temperature becomes higher than that described above by heat generated in the blue LED element itself, it is necessary to improve the resin for the binder of the fluorescent material layer or to employ a binder except resin. Also in case of an ultraviolet LED element, as a change of color is easier to occur and results in severer problems, a binder not to be changed by ultraviolet light becomes necessary.

On the other hand, a method for manufacturing a conventional white light emitting device shown in Fig. 5 (cf. especially PATENT DOCUMENT 1 for detail) has following steps of: preparing a plurality of single elements (blue LEDs) 40 having a substrate 39 made of sapphire, and forming bump electrodes 41 on a Si wafer 42 to be sub-mount members 44 in order to connect a p-side electrode and an n-side electrode of each blue LED element 40 (step (a)); arranging the p-side electrode and the n-side electrode of the each blue LED element to positions of the bump electrodes 41 and connecting through the bump electrodes in a flip-chip manner (step (b)); flattening (uniforming) an upper surface (surface of the sapphire substrate 39 side) by grinding with a grinding tool 50 (step (c)); and forming a plurality of hybrid white light emitting devices provided with a fluorescent material 43 by coating the fluorescent material (fluorescent material paste) on the upper surface and on a side of the blue LED element (step (d)).

Subsequently, there are included steps of: uniforming a thickness so as to obtain a desired chromaticity by grinding the upper surface of the plurality of the hybrid white light emitting devices, namely the fluorescent material layer 43, with a grinding tool 51 (step (e)); forming the hybrid white light emitting devices separately by cutting (dicing) at a border of each hybrid white light emitting device with a cutting tool (dicer) 52 (step (f)); and carrying out a final inspection. In the method by the prior art described above, there exist three problems which decrease a production yield due to the method itself.

Firstly, after the step (b) of mounting the blue LED element 40 on the Si wafer 42 which becomes the sub-mount 44 in a flip-chip manner, when the step (c) of grinding is operated to the sapphire substrate 39 of the blue LED elements 40, stress in the grinding is applied to a connection part of each bump electrode depending on deterioration of sharpness of the grinding tool 50 and cracks possibly occur at the connection part. In this case, if defective products are eliminated as abnormal characteristics in the step of inspection, problems are settled as decreasing of a production yield, but if they are not detected, it leads to defects in a market. Thus, this method includes a cause of a very serious defect from the view point of reliability.

Secondly, in the step (d) of forming the fluorescent material layer 43 by coating the fluorescent material paste, since the fluorescent material layer 43 should be coated only on the top surface and the side of the blue LED element 40, a pattern recognition with high accuracy is necessary in the step of coating, because there exists an area for wire bonding just beside the sub-mount 44 on which the blue LED element 40 is mounted in the flip-chip manner. If errors happen here, the fluorescent material paste is coated on the area for wire bonding. In this case, such a big decreasing of the production yield that a whole wafer becomes a lot-out, because it is impossible to retry by removing the fluorescent material layer 43.

Thirdly, even post steps after preparing the each single element of the blue LED 40 are complicated and need steps of a lot of labor, and this complicacy is one of causes preventing the production yield from improving.

Then, objects of the present invention are to provide a white light emitting device of high luminous efficiency prevented from luminance deterioration even in large electric current range by solving the problems of the hybrid white light emitting device including the problems in the manufacturing method and to provide a method for manufacturing the same with high production yield, including a case of using an ultraviolet light LED, not limited to a white light emitting device using a blue LED element.

### MEANS FOR SOLVING THE PROBLEM

A white light emitting device according to claim 1 of the present invention is characterized in that a light emitting device having a light emitting layer formed with GaN based compound semiconductor layers, includes: an n-side electrode and a p-side electrode formed on one side of the emitting layer; an n-type layer made of a GaN based compound semiconductor laminated on the n-side electrode; semiconductor layers made of the GaN based compound semiconductor including an active layer laminated on the p-side electrode; a light transmitting crystal substrate provided on the semiconductor layers made of the GaN based compound semiconductor; and an oxide layer containing a fluorescent material formed on the light transmitting crystal substrate.

The white light emitting device according to the present invention is different from that with a hybrid structure 100 by the prior art in two points. Firstly, in a fluorescent material coated on a blue LED device, an oxide of an inorganic material which is strong against heat or ultraviolet light and which does not change in color is employed for a binder in place of organic resin for the binder which changes in color by heat. And secondly, although a sub-mount member is indispensable in forming the white light emitting device because it works as a container of the fluorescent material in case of the hybrid structure 100 depending on a manufacturing method, the white light emitting device is obtained without using the sub-mount member in the structure by the present invention.

As this structure prevents the binder of the fluorescent material from change of color caused by heat generated in the blue LED element by energizing and by ultraviolet light of the ultraviolet LED element, a white light emitting device which is remarkably improved in reliability can be obtained because deterioration of a luminance caused by change of color of the binder hardly occurs even in a large current range.

Further, as described in detail later in an explanation of a manufacturing method of forming the oxide layer containing the fluorescent material, this structure needs no sub-mount member for whitening, and then the structure can be simple and solve the problems described above in the manufacturing method itself. Since the white light emitting device is formed by integrating the blue LED element or the ultraviolet LED element and the fluorescent material layer with each other without using the sub-mount member, it becomes possible to reduce a size smaller than that of the hybrid structure 100 by the prior art from the aspect of a size, and to design the white light emitting device with less restriction from package shapes by using this structure. When a protective diode is necessary, it can be built in by connecting to the white light emitting device in reverse polarization and in parallel.

A white light emitting device according to claim 2 is characterized in that the oxide layer containing the fluorescent material is formed by binding the fluorescent material with glass. Principal components of the glass are SiO₂ and B₂O₃, SiO₂, B₂O₃ and ZnO, or SiO₂, B₂O₃ and PbO and the oxide layer containing the fluorescent material can be formed on a light transmitting crystal substrate by using the glass made of these component. In other word, in case of forming the oxide layer with the binder of the glass, when a thermal expansion coefficient of the glass is not set nearly to that of the light transmitting crystal substrate, the glass cracks and peels off. Concretely, it is necessary to keep a difference between both thermal expansion coefficients within 5%. Properties required further to the glass are a high light transmissivity and a sintering temperature of the glass (softening temperature in case of powder glass and temperature of a heat treatment in case of a sol-gel method) of 700°C or less, at which an active layer of the blue LED element is not suffered from undesirable influence, preferably of 600°C or less.

For example, in case that the light transmitting crystal substrate is a sapphire substrate whose thermal expansion coefficient is 7.4x10⁻⁶/°C, principal components of the powder glass having a thermal expansion coefficient nearly equal to that of the sapphire, a high light transmisivity, and a temperature of sintering of 700°C or less are SiO₂ and B₂O₃, and it is preferable to employ glass whose principal components are SiO₂, B₂O₃ and ZnO, or SiO₂, B₂O₃ and PbO, in order to lower the sintering temperature. And in case that the light transmitting crystal substrate is a SiC substrate whose thermal expansion coefficient is 3.7x10-⁶/°C , although glass whose principal components are SiO₂ and B₂O₃ has an approximately same thermal expansion coefficient and a high light transmissivity, it is necessary to shorten a period of sintering considering an influence to a light emitting layer of a blue LED element, because a sintering temperature is 700°C or more. Besides, when principal components of glass are SiO₂ and B₂O₃, the glass can be formed with a sol-gel method, and a heat treatment can be operated at a temperature of 600°C or less by heating after forming the glass with the sol-gel method.

A white light emitting device according to claim 3 is characterized in that the oxide layer containing the fluorescent material includes a porous layer in which fluorescent material particles are bridged with glass. Here, as a light transmitting property of the glass after sintering happens to be reduced when PbO is included in components of the powder glass, in this case, a mixing ratio of the powder glass and the fluorescent material is arranged rich in the fluorescent material (making a density of the fluorescent material large) and the oxide layer containing the fluorescent material is thinned as thin as possible. As a result of this, the oxide layer is formed in a porous structure such that particles of the fluorescent material are bridged with a small amount of the glass binder and an influence of the glass for bridging to a light transmissivity can be reduced to the utmost.

A white light emitting device according to claim 4 is formed such that the emitting layer emits blue light and characterized in that the fluorescent material is made of a fluorescent material converting blue light into light of a complimentary color or a fluorescent material converting blue light into green light and red light. Here, by applying a fluorescent material which converts blue light to light of a complimentary color of the blue light to the oxide layer, white light can be obtained by addition and mixing of the blue light. Further by applying fluorescent materials, which convert blue light to green light and which convert blue light to red light, to the oxide layer, white light can be obtained by the addition and mixing of three elementary colors (blue light of the blue LED device, green light and red light converted by the fluorescent material).

A white light emitting device according to claim 5 is formed such that the emitting layer emits ultraviolet light and characterized in that the fluorescent material is made of a fluorescent material converting ultraviolet light into blue light, green light and red light, and by applying the fluorescent material converting ultraviolet light to blue light, that to green light and that to red light to the oxide layer, a white light emitting device may be obtained by the addition and mixing of lights of three elementary colors.

A white light emitting device according to claim 6 is characterized in that a block light emitting device includes a plurality of unit light emitting devices arranged in a structure of a matrix shape, each of the unit light emitting devices is the light emitting device of one of claims 1 to 5, and constitution in applications such as lighting apparatus or the like which needs a large brightness becomes easy to carry out by forming the block light emitting device. For example, in an area of a light emitting device enlarged simply, current may not flow uniformly at each part, since a VF (forward voltage) varies at each part of the light emitting device. But, by making the block light emitting device and connecting each unit light emitting device in series, as same current flows in each unit light emitting device, constitution to flow uniform current to each part is formed. In addition, production manhours are reduced because it is not necessary to divide into each unit light emitting device.

A manufacturing method according to claim 7 of the present invention is characterized in that a method for manufacturing a unit light emitting device or a block light emitting device of a white light emitting device having a light emitting layer formed with GaN based compound semiconductor layers includes steps of: preparing a wafer in which a structure of a light emitting diode is formed by laminating epitaxial layers having the light emitting layer emitting blue light or ultraviolet light composed of at least GaN based compound semiconductor layers on a light transmitting crystal substrate by an epitaxial vapor growth technique; forming an oxide layer containing a fluorescent material on the light transmitting crystal substrate of the wafer; forming a p-side electrode and an n-side electrode on a surface of the epitaxial layers side; and dividing a wafer into chips along a boarder of a unit light emitting device which includes a plurality of light emitting portions having a continuous epitaxial layer of one conductivity type layer in the light emitting portions, or a block light emitting device in which a plurality of the unit light emitting devices are formed by separating the epitaxial layers electrically.

In this manufacturing method, firstly there is prepared the wafer in which the structure of the light emitting diode is formed by the laminating epitaxial layers (lamination structure having the light emitting layer emitting blue light or ultraviolet light composed of at least GaN based compound semiconductor layers) on the light transmitting crystal substrate such as a substrate made of sapphire by the epitaxial vapor growth technique such as a metal organic chemical vapor deposition method (MOCVD method) or the like (preparation step). Subsequently, there is formed the oxide layer containing the fluorescent material, for example an oxide layer made of the fluorescent material and a glass binder having principal components of SiO₂, B₂O₃ and PbO to bind the fluorescent material, on the light transmitting crystal substrate of the wafer (oxide forming step). The oxide layer may be formed in a thickness of approximately several tens micron meters, although it depends on a density of the fluorescent material. Thereafter, an upper surface of the oxide layer formed is ground (polished) flat so as to be parallel to a lower surface of the epitaxial layer of an opposite side with a surface grinding machine (polishing machine).

Subsequently, the p-side electrode and the n-side electrode are formed on a surface of the epitaxial layers side opposite to the oxide layer (electrode forming step). In this case, the p-side electrode is formed on an exposed surface of the epitaxial layer (on a surface of a side of the p-type layer holding the light emitting layer) and the n-side electrode is formed on a surface of the n-type layer exposed by removing the p-type layer and the light emitting layer by a pattern etching method (selective etching). As the p-side electrode is both an electrode and a reflection mirror of light (reflection mirror), it is important to be made of a material having a high reflection coefficient and easy to make an ohmic contact. Subsequently, while applying current to electrodes and lighting in a wafer state, the oxide layer containing the fluorescent material is ground in a suitable thickness for obtaining suitable color (chromaticity) of emitted light (chromaticity adjusting step). Subsequently, the wafer is divided into chips of LED devices by dividing along a boarder of the unit light emitting device or the block light emitting device by dicing or the like (chip forming step). In this case, an outer shape of the chip may be formed in a shape suitable for obtaining a high efficiency of taking light out. For example, a shape of a cross section may be approximately trapezoidal.

A manufacturing method according to claim 8 is characterized in that the manufacturing method according to claim 7, further includes a step of forming grooves by working the light transmitting crystal substrate to make the grooves before forming the oxide layer. Here, by forming grooves along a boarder of the unit light emitting devices in a U shape or a V shape by a half dicing technique or a sandblast technique, and by forming an oxide layer containing a fluorescent material in the grooves in next oxide forming step, more uniform white light can be obtained in a direction of emitting light, because the chip of the white light emitting device divided into chips in a next chip making step has the oxide layer containing the fluorescent material on a side of the chip.

A manufacturing method according to claim 9 is characterized in that the manufacturing method according to claim 7, further includes a step of adjusting chromaticity to adjust the chromaticity of emitted light by adjusting a thickness of the oxide layer containing the fluorescent material by grinding. Thereby, a desired white light emitting device can be obtained, because variations of a density of the fluorescent material and of a wavelength of light emitted from a light emitting layer can be adjusted.

An object of this working of grooves is to make the outer shape of the chip in a shape in which the efficiency of taking light out improves. Then, total reflection which occurs when light transmits from a material of a high reflection coefficient to that of a low reflection coefficient is reduced, and, for example, by making a cross section in an approximately trapezoidal shape, the efficiency of taking light out can be improved as a result.

The white light emitting device of the structure according to the present invention can be manufactured easily by the manufacturing method according to the present invention, and at the same time, the three problems described in a explanation of the method for manufacturing the white light emitting device of the conventional hybrid type can be solved easily, since the white light emitting device can be formed without mounting the light emitting device on the sub-mount device in the flip-chip manner.

After all, the problem 1 and 2 are solved, since a portion of bumps and a region for a bonding pad are not necessary and since accuracy of pattern recognition in coating a fluorescent material to form a glass layer containing a fluorescent material on an entire surface of the light transmitting crystal substrate of a wafer is not necessary at all. Thereby, reliability on cracks or the like in a portion of bumps is improved, and a production yield can be improved by inhibiting decrease of the production yield caused by a lot-out of a whole wafer. As for the problem 3, since the white light emitting device can be formed without mounting the light emitting device on the sub-mount in the flip-chip manner, there can be achieved simplifying the process, manufacturing with high production yield and reducing a production cost.

### EFFECT OF THE INVENTION

As described above, the white light emitting device according to the present invention is formed by using the oxide of the inorganic material, which is strong against heat or ultraviolet light and which does not change in color, as the binder for the fluorescent material coated around the blue LED element or the ultraviolet LED element, and by using no sub-mount member.

By this structure, as the binder of the fluorescent material does not change in color by heat or ultraviolet light generated in the blue LED element or the ultraviolet LED element by energizing, deterioration of a luminance caused by a change of color of the binder hardly occurs even in energizing in a large current range, and the white light emitting device with high reliability significantly improved can be realized.

In this structure, as the white light emitting device or the block white light emitting device is formed by integrating the blue LED element or the ultraviolet LED element with the fluorescent material layer without using the sub-mount member, a white light emitting device of a package free type not depending on a package shape can be fabricated and applications such as a light source or the like which need large brightness can be constituted easily.

In addition, efficiency of light emission can be improved by enhancing the efficiency of taking light out, by frosting an upper surface of the sapphire substrate from which a principal light is taken out in a state of a frosted glass, by providing the surface with grooves, or by making a chip in a shape having a cross section of an approximately trapezoidal shape. And at the same time, more uniform white light can be obtained in a direction of light emission because the oxide layer containing the fluorescent material can be formed on a side of the blue LED device or the ultraviolet LED device.

In addition, as a sub-mount member is not necessary for manufacturing a white color light emitting device, a constitution becomes simple and the above described problems can be solved by the manufacturing method itself. As a result, a simplified production process, manufacturing with high production yield and manufacturing with reduced cost can be achieved.

### BRIEF DESCRIPTION OF THE DRAWINGS

Figs. 1(a) to 1(c) are figures explaining a detail of the first embodiment of the white light emitting device according to the present invention. Here, (a) is a plan view, (b) a longitudinal sectional view at an A-A line of (c) and (c) a bottom view.
Figs. 2(a) to 2(c) are figures explaining a detail of the second embodiment of the white light emitting device according to the present invention. Here, (a) is a plan view, (b) a longitudinal sectional view at a B-B line of (c) and (c) a bottom view.
Figs. 3(a) to 3(g) are cross sectional views showing each step in the method for manufacturing the white light emitting device of the first embodiment according to the present invention.
Fig. 4 is a cross sectional front view showing a structure of a white light emitting device (white light emitting device of hybrid type) by using a general light emitting element by the prior art.
Figs. 5(a) to 5(f) are cross-sectional views showing each step in an example of a method for manufacturing the conventional white light emitting device (white light emitting device of hybrid type).

### EXPLANATION OF LTTERS AND NUMERALS

- 1:: white light emitting device
(unit light emitting device)
- 2:: block light emitting device
- 3:: light transmitting crystal substrate
- 4:: blue (ultraviolet) LED element
- 6:: epitaxial layer
- 7:: groove
- 8:: oxide layer containing a fluorescent material
- 9:: recessed portion
- 10:: n-side electrode
- 11:: p-side electrode
- 20:: dry film
- 21, 26:: dicing tape
- 22:: nozzle
- 23, 25:: dicing blade
- 24:: grinding tool

### THE BEST EMBODIMENT OF THE PRESENT INVENTION

An explanation will be given below of embodiments of a white light emitting device and a method for manufacturing the same according to the present invention in order from the first embodiment to the fourth embodiment in reference to the drawings.

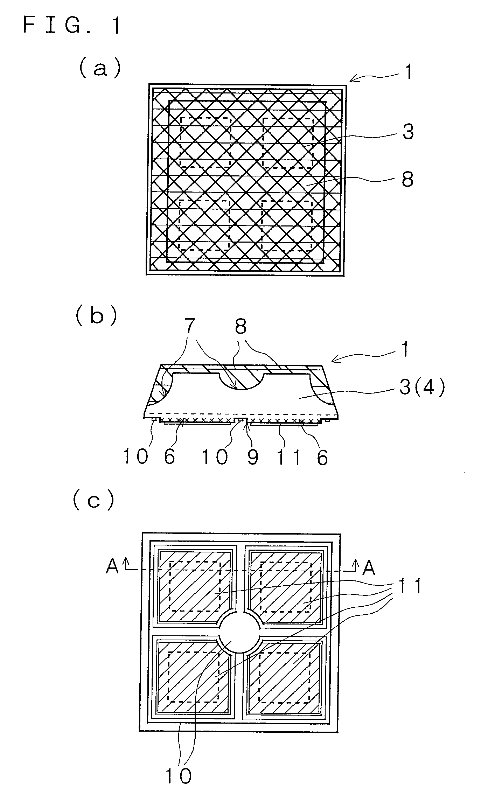

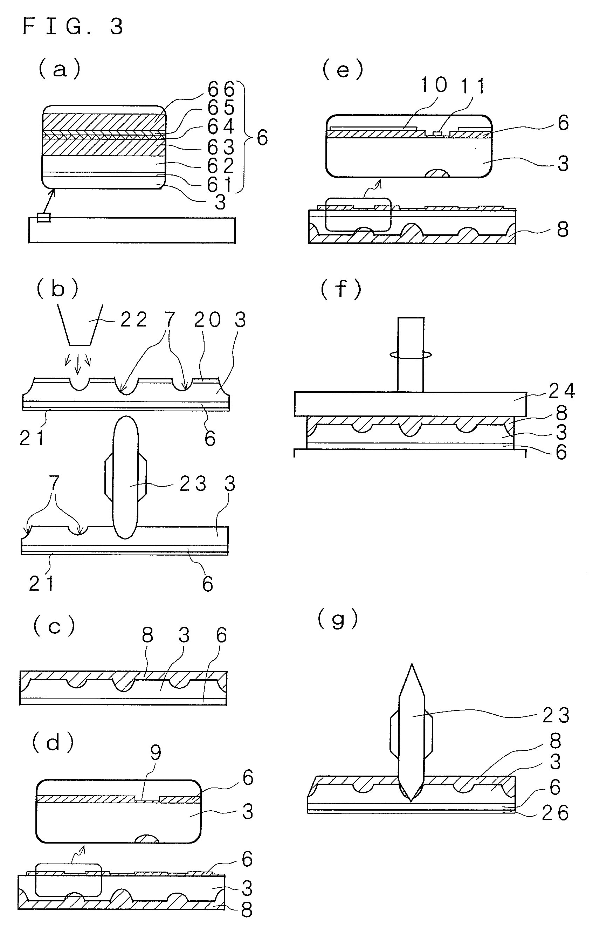

A white light emitting device of the first embodiment is shown in Figs. 1(a) to 1(c). And a method for manufacturing it is composed of steps (a) to (g) as shown in Figs. 3(a) to 3 (g) and is a method for manufacturing a plurality of the white light emitting devices 1 in a lump.

The white light emitting device 1 in this case is a a large type white LED device for use in, for example, a light source as a unit light emitting device as shown in Figs. 1(a) to 1(c). Here, a unit light emitting device means a light emitting device in which one or more emitting layers emit light by a pair of a p-side electrode and an n-side electrode, including a light emitting device in which a plurality of light emitting layers (light emitting portions) emit light by a plurality of p-side electrodes and one common n-side electrode as shown in Fig. 1. The example in Fig. 1 has a plurality of the light emitting layers, but adjacent light emitting layers are formed so as to be in common epitaxial layer in the neighborhood of a transparent substrate. The white light emitting device 1 is composed of a blue LED element 4 and an oxide layer 8 containing a fluorescent material integrated with the blue LED element 4. The blue LED element 4 is formed: with GaN based compound semiconductor layers (epitaxial layer 6) formed by laminating a buffer layer, an n-type layer, a light emitting layer emitting blue light and a p-type layer in this order, on a light transmitting crystal substrate such as sapphire substrate; by forming a p-side electrode 11 on a surface of the p-type layer of the epitaxial layer 6 and an n-type electrode 10 on a bottom surface of a recessed portion 9 of the n-type layer exposed by etching a part of the p-type layer and the light emitting layer selectively; and by forming grooves 7 on a surface of the sapphire substrate 3, from which light is taken out so that a cross sectional shape of one of four sections of the p-side electrode 11 separated in order to improve efficiency of taking the blue light out by the grooves 7 is approximately trapezoidal. The oxide layer 8 is formed on the surface of the sapphire substrate 3, from which light is taken out, and inside of the groove 7, by sintering a fluorescent material of YAG and a glass binder composed of principal components of SiO₂, B₂O₃ and PbO to bind the fluorescent material. The white light emitting device is a device in which white light is emitted outside from a surface of the oxide layer 8, by changing blue light emitted by the blue LED element through the oxide layer 8. That is, the blue LED element is mounted such that the substrate is up side (so called face down type), in which electrodes are bonded and in which the oxide layer 8 of an opposite surface is a surface for taking out principal light. Then, Rh or Ag of a high reflection coefficient is used for the p-side electrode in order to reflect the blue light traveling downward from the light emitting layer so as to travel upward, efficiently. The n-side electrode 10 is formed in a stripe shape surrounding the p-side electrodes separated into four pieces and connected to a circular electrode pad in a center.

An explanation will be given below of a method for manufacturing the white light emitting device in order of step (a) to (g) shown in Fig. 3. At first, in the step (a), there is prepared an LED wafer epitaxialy grown and provided with the epitaxial layer 6 formed by laminating GaN based compound semiconductor layers which are formed by laminating, a GaN buffer layer 61, an n-type GaN layer 62, an n-type AlGaN layer 63, an MQW layer 64, a p-type AlGaN layer 65 and a p-type cap layer 66 on the sapphire substrate, in this order by a metal organic vapor deposition method or the like (preparation step).

Subsequently, in step (b), grooves 7 are formed on an upper surface of the sapphire substrate 3 of the LED wafer along boarders corresponding to the blue LED element 4 of the large type and along centers of them in order to improve efficiency of taking light out. A cross section of the groove is a U shape or V shape having, for example, a width of the groove at the boarder of approximately 200 to 400 µm and a depth of that of approximately 150 to 250 µm, and a width of the center groove of approximately 200 to 300 µm and a depth of that of 50 to 150 µm. This process can be carried out by a sandblast technique of grinding with abrasive powder blasted through a nozzle 22 using a dry film as a mask or a dicing technique of dicing with a dicing blade 23. By this process, a shape of a cross section of each section separated into four pieces by the groove of the blue LED element of the large type is approximately trapezoidal and efficiency of taking light out can be improved. Numeral 21 represents a dicing tape.

In step (c), a paste of a mixture of a fluorescent material of YAG, powder glass having principal components of SiO₂, B₂O₃ and PbO, which bind the fluorescent material, and a small amount of resin (resin is vaporized thoroughly in sintering at approximately 300°C) is coated on the sapphire substrate 3 (including inside of the groove 7), and sintered in an air atmosphere at a temperature of approximately 500 to 600 °C by charging in an electric furnace (oxide (glass) layer forming step). The powder glass has characteristics of a thermal expansion coefficient of 7.4x10⁻⁶/°C nearly equal to that of the sapphire substrate, a sintering temperature of approximately 500 to 600°C and a visual light transmissivity of 90% or more. Although a ratio of mixing the YAG fluorescent material and the powder glass is arranged so that the ratio of the powder glass is large, namely, rich in glass, and a thickness of the oxide layer 8 is arranged thick, in case of a high light transmissivity of glass after sintering, on the other hand, the ratio of the fluorescent material is arranged large, namely, rich in fluorescent material, to form a porous structure only by bridging the fluorescent material powder with glass, and a thickness of the oxide layer 8 is preferably formed thin utmost in case of a low light transmissivity of glass. The porous structure may be formed by a ratio of the fluorescent material of 60% or more, preferably 70% or more. In this case, the oxide layer 8 is formed in a thickness of a few tens µm. Thereafter, an upper surface of the oxide layer 8 formed is ground (polished) so as to be parallel to a lower surface of the epitaxial layer of an opposite side with a surface grinding machine (polishing machine).

Subsequently, in step (d), an SiO₂ layer is formed on a surface of the epitaxial layer 6, and thereafter, a part of the SiO₂ layer is removed only of the recessed portion 9 in order to form an n-side electrode 10 by etching, and by removing the p-type cap layer 66, the p-type AlGaN layer 65, the MQW layer 64, the n-type AlGaN layer 63 successively by a plasma etching method (RIE) using chloride gas to expose the n-type GaN layer 62 (etching step). Here, if the oxide layer 8 is influenced by this etching step, the etching step may be operated before the oxide layer forming step.

In the next step (e), a p-side electrode 11 is formed by laminating layers made of Rh or Ag having high reflection coefficients, Ni and Au on an upper surface of the p-type cap layer 66 of the epitaxial layer 6 exposed by removing the SiO₂ layer, and also an n-side electrode 10 is formed by laminating layers made of Ti and Au on an upper surface of the n-type GaN layer 62 exposed in the recessed portion (electrode forming step).

Subsequently, in step (f), the oxide layer 8 containing the fluorescent material is ground in a suitable thickness so as to emit light of a suitable color (chromaticity) with a grinding tool 24, while applying current to electrodes and emitting light in a state of a wafer (chromaticity adjusting step).

In step (g), the wafer is divided into chips by dicing and separating along boarders of white light emitting devices (unit light emitting device) 1 of a large type so that diced portions of the oxide layer 8 make a V shape in order to improve efficiency of taking out light, a surface from which a principal light is taken out (chip forming step). A shape of a cross section of the chip is approximately trapezoidal and the efficiency of taking out light is improved.

As described above, by this embodiment (the first embodiment), as the oxide layer 8 containing a fluorescent material and the blue LED element are integrated with each other and glass is used as a binder for the fluorescent material in the oxide layer 8, a unit white light emitting device of a large type can be obtained for a light source for lighting, color of which is not changed by heat caused by a large current and which has high luminance and high reliability.

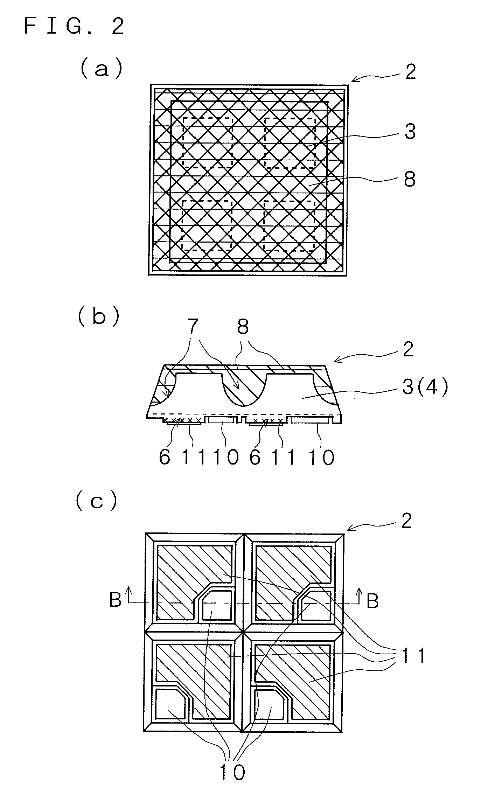

A white light emitting device of the second embodiment is a block light emitting device 2 shown in Fig. 2 and a method for manufacturing the device is same as that of the first embodiment. The block light emitting device means a light emitting device in which adjacent light emitting layers including the n-type epitaxial layer are not continuous and each of which is separated by grooves. In Fig. 2, unit light emitting devices having one light emitting layer, respectively are formed on a light transmitting substrate electrically separated mutually. A block light emitting device may be formed by arranging a plurality of unit light emitting device as shown in Fig. 1, in which the n-type epitaxial layer is common while having a prularity of light emitting layers (light emitting portions), in matrix shape further. For example it is possible to make a block light emitting device by arranging four unit light emitting devices each of which has four light emitting layers as shown in Fig. 1, in matrix shape. In this case, the block light emitting device has four unit light emitting devices and sixteen light emitting layers (light emitting portions).

In this case shown in Fig. 2, the block light emitting device 2 is formed by arranging unit white light emitting devices, each of which has a side of approximately 0.3 mm, in two lines and two rows. A structure of the unit light emitting device is same as that shown in Fig. 1 except difference of a device size and electrodes pattern. As a manufacturing method in this case is composed of nearly same steps as those of the first embodiment, although the figure is not shown. Differences are only electrodes pattern of a blue LED element and depth and position of grooves.

Since the block light emitting device 2 can be a white light emitting device without mounting in a flip-chip manner, the block light emitting device 2 has same merits as those described in the first embodiment and also has the most suitable structure for a white light emitting device for use in large current such as light sources for lighting. In case of manufacturing a white light emitting device of a large type, there are two ways, enlarging an area of an electrode by enlarging an area of the light emitting device simply as shown in Fig. 1 and enlarging an area by connecting block light emitting devices formed with white light emitting devices of a small size in series as shown in Fig. 2. From the aspect of a method for applying current to each part of the white light emitting device uniformly, although there is no difference in case that variation of VF (forward voltage) in the light emitting device does not exist, it is preferable to make a block light emitting device as shown in Fig. 2 in order to apply current to each part of the light emitting device more uniformly and improve efficiency of light emission, because the variation is large in a GaN based compound semiconductor light emitting device. Taking a light source for lighting into consideration, as a driving voltage of 100 V is preferable, connection in series is suitable to constitute the light source for lighting. Furthermore, production manhours can be reduced because separating into unit light emitting devices is not necessary. As the light emitting device has been already formed in a white light emitting device, it becomes package free not depending on package types, although there is a limitation in whitening color in packaging in the prior art.

In a white light emitting device of the third embodiment, a light transmitting crystal substrate 3 of a white light emitting device shown in Fig. 1 is a SiC substrate and a binder of an oxide layer 8 containing a fluorescent material is glass of principal components of SiO₂ and B₂O₃ having approximately same thermal expansion coefficient as that of the SiC substrate. Although its manufacturing method is nearly same as that in the first embodiment, the oxide layer 8 containing the fluorescent material is formed by forming most part of a glass skeleton by reactions of hydrolysis and polycondensation by dispersing powder of the fluorescent material into an alkoxide solution (prepared by adding B(OCH(cH₃)₂)₃ to Si(OC₂H₅)₄ partially hydrolyzed beforehand) and by carrying out a heat treatment at a temperature of 500 to 600°C and for a period of 10 to 30 minutes.

A white light emitting device of the fourth embodiment is a block light emitting device shown in Fig. 2 which has a light transmitting crystal substrate 3 made of SiC and a binder made of glass of principal components of SiO₂, and B₂O₃ same as that in the first embodiment.

Although the embodiments described above are examples of using a blue LED element in which a color of light emitted at a light emitting layer is blue, idea is same in case of using an ultraviolet LED element emitting ultraviolet light. Here, a material converting ultraviolet light to blue light, green light and red light maybe employed as a fluorescent material of the oxide layer 8 containing the fluorescent material.

### INDUSTRIAL APPLICABILITY

The light emitting device according to the present invention, can be used for light source of wide fields such as back lights for liquid crystal display devices or the like, light emitting devices of many colors such as white, blue, or the like, lighting apparatus and the like.

## Claims

1. A light emitting device having a light emitting layer formed with GaN based compound semiconductor layers, comprising:
an n-side electrode and a p-side electrode formed on one side of the emitting layer;
an n-type layer made of a GaN based compound semiconductor laminated on the n-side electrode;
semiconductor layers made of the GaN based compound semiconductor including an active layer laminated on the p-side electrode;
a light transmitting crystal substrate provided on the semiconductor layers made of the GaN based compound semiconductor; and
an oxide layer containing a fluorescent material formed on the light transmitting crystal substrate.

2. The light emitting device according to claim 1, wherein the oxide layer containing the fluorescent material is formed by binding the fluorescent material with glass, principal components of the glass being SiO₂ and B₂O₃, SiO₂, B₂O₃ and ZnO, or SiO₂, B₂O₃ and PbO.

3. The light emitting device according to claim 1 or 2, wherein the oxide layer containing the fluorescent material comprises a porous layer in which fluorescent material particles are bridged with glass.

4. The light emitting device which can emit white light according to one of claims 1 to 3, wherein the fluorescent material is made of a fluorescent material converting blue light into light of a complimentary color or a fluorescent material converting blue light into green light and red light.

5. The light emitting device which can emit white light according to one of claims 1 to 3, wherein the fluorescent material is made of a fluorescent material converting ultraviolet light into blue light, green light and red light.

6. A block light emitting device comprising,
a plurality of unit light emitting devices arranged in a structure of a matrix shape, each of the unit light emitting devices being the light emitting device of one of claims 1 to 5.

7. A method for manufacturing a light emitting device having a light emitting layer formed with GaN based compound semiconductor layers comprising steps of:
preparing a wafer in which a structure of a light emitting diode is formed by laminating epitaxial layers having the light emitting layer composed of at least GaN based compound semiconductor layers on a light transmitting crystal substrate by an epitaxial vapor growth technique;
forming an oxide layer containing a fluorescent material on the light transmitting crystal substrate of the wafer;
forming a p-side electrode and an n-side electrode on a surface of the epitaxial layers side; and
dividing a wafer into chips along a boarder of a unit light emitting device which includes a plurality of light emitting portions having a continuous epitaxial layer of one conductivity type layer in the light emitting portions, or a block light emitting device in which a plurality of the unit light emitting devices are formed by separating the epitaxial layers electrically.

8. The manufacturing method according to claim 7, further comprising a step of forming grooves by working the light transmitting crystal substrate to make the grooves before forming the oxide layer.

9. The manufacturing method according to claim 7, further comprising a step of adjusting chromaticity to adjust the chromaticity of emitted light by adjusting a thickness of the oxide layer containing the fluorescent material by grinding.
